Europäisches Patentamt

European Patent Office

Office européen des brevets

(11) Publication number: **0 136 587 B1**

## EUROPEAN PATENT SPECIFICATION

(45) Date of publication of patent specification: **17.04.91**

(51) Int. Cl.⁵: **G11B 20/18**, //H03M13/00, G11B7/00,G06F11/10

(21) Application number: **84110573.7**

(22) Date of filing: **05.09.84**

(54) Error correction circuit.

(30) Priority: **06.09.83 JP 163675/83**
**06.09.83 JP 163678/83**

(43) Date of publication of application:
**10.04.85 Bulletin 85/15**

(45) Publication of the grant of the patent:
**17.04.91 Bulletin 91/16**

(84) Designated Contracting States:
**DE FR GB NL**

(56) References cited:
EP-A- 0 061 345      EP-A- 0 072 640
EP-A- 0 096 109      EP-A- 0 105 499
FR-A- 2 400 801      GB-A- 2 081 479

INTERNATIONAL ZURICH SEMINAR ON DIGI-
TAL COMMUNICATIONS, Zurich, 4th-6th
March 1980, Proceedngs IEEE catalog no.
80CH1521-4 COM, pages G4.1 - G4.5, IEEE,
New York, US; P. STAMMNITZ: "Error protec-
tion of 34 MBIT/S DPCM encoded TV signals
with multiple error correcting BCH codes"

(73) Proprietor: **KABUSHIKI KAISHA TOSHIBA**
**72, Horikawa-cho Saiwai-ku**
**Kawasaki-shi Kanagawa-ken 210(JP)**

(72) Inventor: **Nagumo, Masahide c/o Patent Div.,**
**Toshiba Corp.**
**Principal Office 1-1, Shibaura 1-chome**
**Minato-ku Tokyo(JP)**
Inventor: **Kojima, Tadashi c/o Patent Div.,**
**Toshiba Corp.**
**Principal Office 1-1, Shibaura 1-chome**
**Minato-ku Tokyo(JP)**
Inventor: **Inagawa, Jun c/o Patent Div.,**
**Toshiba Corp.**
**Principal Office 1-1, Shibaura 1-chome**
**Minato-ku Tokyo(JP)**

(74) Representative: **Blumbach Weser Bergen**
**Kramer Zwirner Hoffmann Patentanwälte**
**Radeckestrasse 43**
**W-8000 München 60(DE)**

**Description**

The present invention relates to an improvement in an error correction circuit suitable for use in a digital audio disc (referred to hereafter as DAD) playback apparatus of an optical compact disc (referred hereafter as CD).

In recent years, its has becoming popular in the field of acoustic technology to adopt digital recording systems making use of a PCM (Pulse Coded Modulation) technique, in order to realize playback with as high a fidelity as possible. This kind of technique, usually referred to as "digital audio system", is known as a technique which exhibits audio characteristics much superior to that of conventional analog type playback systems,without having any dependency on the characteristics of the recording medium.

The technique of the type described, making use of a disc as the recording medium, is generally called a "DAD" system, and various types of recording/playback methods have been proposed such as an optical type method, electrostatic type method, and mechanical type method. This new recording/playback technique, on the other hand, requires a playback apparatus which can satisfy various functions and a high standard of performance which could never be achieved by the prior art, regardless of the type of the recording and playback techniques.

For instance, in case of the CD system, the disc used as the medium is made of a transparent resin and has a diameter of about 12 cm and a thickness of about 1.2 mm, the disc being coated with a metallic thin film in which are formed pits corresponding to the digital PCM signal. The disc is driven by a system called CLV (Constant Linear Velocity) system at a varying rotation speed of about 500 to 200 r.p.m. An optical pick-up housing a semiconductor laser and a photoelectric conversion element is driven by a linear tracking system so that the laser beam scans radially the disc from the inner side to the outer side of the disc. The disc usually has a track pitch of 1.6 $\mu$m and has a program area (radial range of 25 to 58 mm) which is large enough to store the information for a one-hour stereophonic playback on each side of the disc. In addition, index data and other associated data are stored in the lead-in area (radial range 23 to 25 mm).

In the DAD system of the type described, it is required to facilitate an easy generation of a pit synchronizing signal during playback and to realize a stable data slice by using narrow band frequency characteristics of the RF signal read by the optical pick-up, the recording of digitized data is conducted after such a modulation that the interval of inversion of polarity always falls between the maximum and minimum polarity inversion interval. In case of DAD playback apparatus of optical CD system, an EFM (Eight to Fourteen Modulation) is ordinarily used as the modulation system. Briefly, this modulation system is to divide the digitized data at a unit of 8-bit and to record the same after modulation to a 14-bit data. In the playback, therefore, the 14-bit data is demodulated into original 8-bit digitized data.

The 8-bit digitized data, produced by the demodulation of the 14-bit data reproduced from the disc, is lend to an error correction circuit in which the error correcting operation is conducted.

In the optical CD type DAD playback apparatus, cross interleaved Reed-Solomon codes (referred hereafter as CIRC codes) are used as the error correcting code. CIRC codes are obtained by submitting Reed-Solomon codes, which are a kind of Bose-Chaudhuri-Hocquenghem (BCH) codes and are generally regarded as the most effective random error correction codes hitherto known to a signal processing called "cross interleaving." CIRC codes thus obtained are sensitive enough to correct burst errors. Reed-Solomon codes can be decoded in the same way as other BCH codes, thereby correcting errors.

A discussion will be made hereinafter as to the method of decoding of typical Reed-Solomon codes consisting of k piece of information data symbols and (n-k) piece of inspection symbols, i.e., consisting of n piece of symbols. It is noted here that these symbols are the elements of a Galois field $GF(2^m)$ which is a definite field having m piece of binary bits, i.e., $2^m$ elements. In this case, the generator polynominal H(x) having Reed Solomon code for correcting an error a t number of times is given either by the following Equation (1) for BCH codes or (2) for Reed-Solomon codes, where $\alpha$ is a primitive element of Galois field $GF(2^m)$:

$$H(x) = (x + \alpha)(x + \alpha^2) \cdots (x + \alpha^{2t}) \qquad (1)$$

$$H(x) = (x + \alpha^0)(x + \alpha) \cdots (x + \alpha^{2t-1}) \qquad (2)$$

If we let U(x), V(x) and E(x) denote the recording signal polynominal, the playback signal polynominal and the error polynominal, respectively. Then, these polynominals satisfy the following relationship.

$$V(x) = U(x) + E(x) \qquad (3)$$

The coefficients of polynominals are contained in the Galois field $GF(2^m)$. If we let $x_j$ denote an error location, and let $Y_j$ denote the value of the error at the error location $X_j$, the error polynominal $E(x)$ can then be given as:

$$E(x) = \sum_j Y_j X_j \qquad (4)$$

where $\Sigma$ is the sum of the errors at all of the error locations.

Here, syndrome $S_i$ is defined here by:

$$S_i = V(\alpha^i) \qquad (5)$$

where, $i = 0, 1, \cdots, 2t-1$ .

Then, from equation (3) we have:

$S_i = U(\alpha^i) + E(\alpha^i)$

Both $U(x)$ and $H(x)$ can be divided without leaving a remainder. As a result, the following therefore holds true:

$S_i = E(\alpha^i)$

From Equation (4) it is evident that syndrome $S_i$ may be expressed

$$S_i = E(\alpha^i) = \sum_j Y_j (\alpha^j)^i \qquad (6)$$

as follows:

Let $X_j = \alpha^j$, $X_j$ represents the error location at $\alpha^j$. Then

$$S_i = \sum_j Y_j X_j^i$$

$$\sigma(x) = \prod (x - X_j) = x^e + \sigma_1 x^{e-1} + \ldots + \sigma_e \qquad (7)$$

The error location polynominal $\sigma(x)$ is defined as follows.

where e is the number of errors. The coefficients $\sigma_1$ to $\sigma_e$ of $\sigma(x)$ are related to the error syncrome $S_i$ as shown below:

$$S_{i+e} + \sigma_1 S_{i+e-1} + \cdots + \sigma_{e-1} S_{i+1} + \sigma_e S_i = 0 \qquad (8)$$

Briefly, the above-explained process of decoding of the Reed-Solomon code is as follows.

(I) To calculate syndrome $S_i$ in accordance with Equation (5).

(II) To obtain coefficients $\sigma_1$ to $\sigma_e$ contained in the error location polynominal $\sigma(x)$ in accordance with Equation (8).

(III) To determine the root $X_j$ of the error location polynominal $\sigma(x)$ in accordance with Equation (7).

(IV) To determine the error polynominal $E(x)$ in accordance with Equation (4), after determining the value $Y_j$ in accordance with Equation (6).

(V) To effect an error correction in accordance with Equation (3).

By using the steps listed above, the steps needed to decode a Reed-Solomon code consisting of many block data each containing four inspection symbols will be described as a practical example of the error correction. This code is represented by the following generator polynominal $H(x)$:

$H(x) = (x + 1)(x + \alpha)(x + \alpha^2)(x + \alpha^3)$ .

In this case, this polynominal $H(x)$ permits the correction of error up to double error, as explained hereinafter. The Reed-Solomon code may be decoded by the following process.

(I) To calculate syndromes $S_0$ to $S_3$:

(II) Equation (8) is rewritten for each of the cases of $e = 1$ and $e = 2$ as follows.

**In case of e = 1:**

$$S_1 + \sigma_1 S_0 = 0$$
$$S_2 + \sigma_1 S_1 = 0 \tag{9}$$
$$S_3 + \sigma_1 S_2 = 0$$

**In case of e = 2:**

$$S_2 + \sigma_1 S_1 + \sigma_2 S_0 = 0$$
$$S_3 + \sigma_1 S_2 + \sigma_2 S_1 = 0 \tag{10}$$

It is assumed here that the actual decoder commences its operation from the state of $e = 1$. In this case, it is necessary to determine the solution $\sigma_1$ which satisfies the simultaneous Equation (9). If no solution $\sigma_1$ is found, the decoder must find solutions $\sigma_1$ and $\sigma_2$ which satisfy the simultaneous Equation (10). If such solutions cannot be found, it is deemed that the condition of $e = 3$ is met.

The solution $\sigma_1$ of simultaneous Equation (9) can be expressed by:

$\sigma_1 = S_1/S_0 = S_2/S_1 = S_3/S_2$

The solution $\sigma_1$ and $\sigma_2$ of simultaneous Equation (10) is:

$\sigma_1 = (S_0 S_3 + S_1 S_2)/(S_1^2 + S_0 S_2)$ , and

$\sigma_2 = (S_1 S_3 + S_2^2)/(S_1^2 + S_0 S_2)$

(III) If the coefficient $\sigma_1$ in the error location polynominal is obtained, find the root of the error location polynominal in accordance with Equation (7).

**In the case of e = 1:**

$$\sigma(x) = x + \sigma_1 = 0$$

Therefore, $Z_1 = \sigma_1$.

**In the case of e = 2:**

$$\sigma(x) = x^2 + \sigma_1 x + \sigma_2 = 0 \tag{11}$$

Substituting the elements of the Galois field $GF(2^m)$ in Equation (11) one after another will yield roots $Z_1$ and $Z_2$.

(IV) If the roots of the error location polynominal are found, determine the error value $Y_j$ in accordance with Equation (6).

In the case of $e = 1$ :

$S_0 = Y_1$

Therefore, $Y_1 = S_0$.

In the case of $e = 2$ :

$S_0 = Y_1 + Y_2$

$S1 = Y_1 Z_1 + Y_2 Z_2$

Therefore,

$Y_1 = (Z_2 S_0 + S_1)/(Z_1 + Z_2)$ and

$Y_2 = S_0 + Y_1$

(V) The correction of the error is conducted in accordance with the correction values $Y_1$ and $Y_2$ thus obtained.

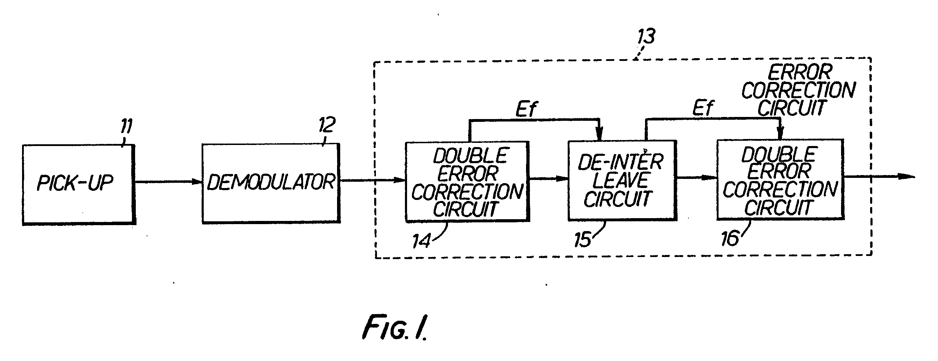

Fig. 1 is a block diagram of a conventional error correction circuit constituted by an actual decoding system of CIRC codes based on the theory heretofore described. Pick-up 11 is adapted to reproduce an RF

4

signal from the disc. The RF signal is converted by a data slice circuit (not shown) into a digitized data and is used for the extraction of the synchronizing signal for the self-locking purpose, and is given to a demodulating circuit 12. As explained before, demodulating circuit 12 carries out the EFM demodulation for converting the 14-bit data recorded in the disc into 8-bit data and delivers the demodulated symbols to the error correcting means 13.

Error correcting means 13 is of a cross interleave double correction system constituted by a double correction circuit 14, de-interleave circuit 15 and a double correction circuit 16. Namely, when the result of the error judgement in the double correction circuit 14 has proved that the error is correctable, the error correction is conducted in the manner explained before and the corrected value is delivered to a D/A converter (not shown) through de-interleave circuit 15 and double correction circuit 16. On the other hand, when the error correcting capacity is exceeded, the error correction is not performed but the error flag $E_f$ representing the error location is added to the demodulated symbols and is outputted to de-interleave circuit 15 for a de-interleave processing together with the error flag $E_f$. Then the error correction is effected by double correction circuit 16.

In the conventional error correction circuit, the coefficients $\sigma_i$ of the error location polynominal $\sigma(x)$ are determined by the simultaneous Equations (9) and (10) and the number of errors is judged to determine whether the error is singular, double or triple. Then the error location polynominal $\sigma(x)$ is selected in accordance with the error number and the root (error location) is determined. The error correction is conducted after determination of the error pattern. As stated before, the coefficients $\sigma_i$ are given as follows when the conditions of the simultaneous Equations (9) and (10) are met, respectively.

In case of Equation (9) :

$$\sigma_1 = \overline{S_1/S_0} = \overline{S_2/S_1} = \overline{S_3/S_2}$$

In case of Equation (10) :

$$\sigma_1 = \overline{(S_0S_3} + \overline{S_1S_2)/(S_1}^2 + S_0S_2)$$

$$\sigma = (S_1S_3 + S_2{}^2)/(S_1{}^2 + S_0S_2)$$

In either case, it is necessary to effect a dividing operation. As well known, dividing circuits are rather complicated although multiplying circuits can have a comparatively simple construction.

An error correction circuit performing calculations on the basis of the equations mentioned in claim 1 is disclosed in the document EP-A-61 345. In order to obtain products and quotients of the elements of the Galois field, this prior art uses conversion ROMs which become fairly large for storing all the necessary data.

This gives a rise to the demand for a simple circuit which can perform the judgement as to whether the error is a singular error, double error or a tripple error.

## SUMMARY OF THE INVENTION

It is on object of the present invention to provide an error correction circuit which can perform an error judgement at a high acuracy with a simple circuit arrangement.

Another object of the present invention is to provide an error correction circuit which can perform algebraic operations such as multiplication and addition on the elements of the Galois field thereby finding error locations and error patterns in a short time.

These objects are achieved in the error correction circuit of the present invention, as claimed in the single claim.

Additional objects, advantages, and features of the present invention will further become apparent to persons skilled in the art from a study of the following description and of the accompanying drawings, in which:

## BRIEF DESCRIPTION OF THE DRAWINGS

Fig. 1 is a block diagram of a prior art error correction circuit relating to the field of the invention.

Fig. 2 is a block diagram of an embodiment of an error correction circuit according to the present invention.

Fig. 3 is a flow chart for explaining the operation of the embodiment shown in Fig. 2.

Figs. 4 and 5 are timing charts for explaining the operation of the embodiment shown in Fig. 2.

## DESCRIPTION OF THE PREFERRED EMBODIMENT

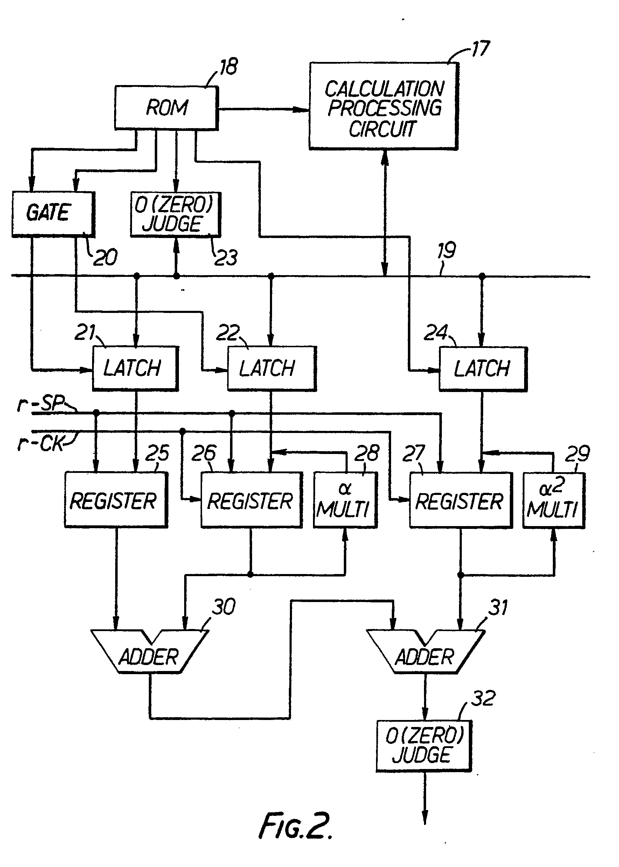

The present invention will now be described in detail with reference to the accompanying drawings; Fig. 2 to Fig. 5. Throughout the drawings like reference numerals and letters are used to designate like or equivalent elements for the sake of simplicity of explanation.

Before describing an enbodiment of the present invention, an explanation will be made hereinafter as to the principle of the error judging means as used in the error corection circuit of the present invention.

By way of example, it is assumed here that the Galois field is $GF(2^8)$. It is also assumed that the generating polynominal $H(x)$ is given by:

$H(x) = (x + 1)(x + \alpha)(x + \alpha^2)(x + \alpha^3)$

where $\alpha$ represents the root of the polynominal.

It is further assumed that the number $n$ of the symbols of the correction blocks is 32, and that the polynominal $U(x)$ of the recording operation as expressed by the following equation is divisible by $H(x)$.

$H(x) = U_{31}x^{31} + U_{30}x^{30} + ... + U_1x^1 + U_0x$

$= U_{31}x^{31} + U_{30}x^{30} + ... + U_1 + U_0$

In this case, the following condition is met as described before.

$U(1) = U(\alpha) = U(\alpha^2) = U(\alpha^3) = 0$

The above-mentibned equation, however, is not satisfied when the error is generated in the reproducing operation. Namely, in the case where the error is singular, the syndromes $S_0$ to $S_3$ are represented as follows, when the error locations and the error patterns are expressed by $\alpha^i$ and $e_i$, respectively.

$S_0 = e_i$

$S_1 = e_i\alpha^i$

$S_2 = e_i\alpha^{2i}$

$S_3 = e_i\alpha^{3i}$

Therefore, the following simultaneous Equation (12) is established.

$$
\begin{aligned}
S_1 + \alpha^i S_0 &= 0 \\
S_2 + \alpha^i S_1 &= 0 \\
S_3 + \alpha^i S_2 &= 0
\end{aligned}
\tag{12}
$$

This simultaneous Equation (12) corresponds to simultaneous Equation (9) mentioned before. Therefore, $\alpha^0$ to $\alpha^{31}$ are successively substituted for $x$ in the following equation:

$$
S_1 + xS_0 = 0
\tag{13}
$$

and the error location is identified as the value $x$ which provides the value 0 of the above-shown formula.

In the case where the error is a double error, the syndromes $S_0$ to $S_3$ are given as follows, when the error locations are expressed as $\alpha a$ and $\alpha^b$ while the error patterns are represented by $e_a$ and $e_b$, respectively.

$S_0 = e_a + e_b$

$S_1 = e_a\alpha^a + e_b\alpha^b$

$S_2 = e_a\alpha^{2a} + e_b\alpha^{2b}$

$S_3 = e_a\alpha^{3a} + e_b\alpha^{3b}$

Consequently, the condition of the following simultaneous Equation (14) is met.

$$
\begin{aligned}
S_2 &= (\alpha^a + \alpha^b)S_1 + \alpha^a\alpha^b S_0 \\
S_3 &= (\alpha^a + \alpha^b)S_2 + \alpha^a\alpha^b S_1
\end{aligned}
\tag{14}
$$

The simultaneous Equation (14) corresponds to simultaneous Equation (10).

Representing $(\alpha^a + \alpha^b)$ and $\alpha^a\alpha^b$ by A and B, respectively, the values $\alpha^a$ and $\alpha^b$ are determined as the roots of the following quadratic equation.

$$x^2 + Ax + B = 0 \qquad\qquad (15)$$

Further, the following conditions arc derived from simultaneous Equation (14).

$A = (S_1 S_2 + S_0 S_3)/(S_1^2 + S_2 S_0)$

$B = (S_2^2 + S_3 S_1)/(S_1^2 + S_2 S_0)$

. Using r1, r2 and r3 meeting the requirements of the following simultaneous Equation (16):

$$
\begin{aligned}
S_1^2 + S_2 S_0 &= r_3 \\
S_1 S_2 + S_0 S_3 &= r_2 \qquad\qquad (16)\\
S_2^2 + S_3 S_1 &= r_1
\end{aligned}
$$

Equation (15) can be rewritten as follows.

$x^2 + (r_2/r_3)x + r_1/r_3 = 0$ (where $r_3 = 0$)

Since $\alpha^a$ and $\alpha^b$ are roots of the above quadratic equation, they are also the roots of the following equation.

$$r_3 x^2 + r_2 x + r_1 = 0 \qquad\qquad (17)$$

Then, $\alpha^0$ to $\alpha^{31}$ are successively substituted for x in Equation (17), and the error location is identified as the value of x which makes the value of Equation (17) zero.

Thus, in case of the singular error, $\alpha^0$ to $\alpha^{31}$ are successively substituted for the x in Equation (13) and the singular error is judged from the fact that Equation (13) has a root which can make Equation (13) meet. On the other hand, in the case of the double error, $\alpha^0$ to $\alpha^{31}$ are successively substituted for the x in Equation (17) and the double error is judged by the fact that Equation (17) has two roots which can make Equation (17) meet.

In the case of the singular error, a following equation is derived from simultaneous Equation (12).

$S_1^2 + S_2 S_0 = S_2^2 + S_1 S_3 = S_1 S_2 \, S_0 S_3 = 0$

Comparing the above equation with simultaneous Equation (16), it is understood that the following condition is met.

$r_3 = r_2 = r_1 = 0$

Since when the condition: $r_3 \neq 0$ is met in the case of a duble error, it is judged that the error is double, triple or of higher degree. On the other hand, when the condition: $r_3 = 0$ is met, it is judged that the error is singular or triple or of higher degree.

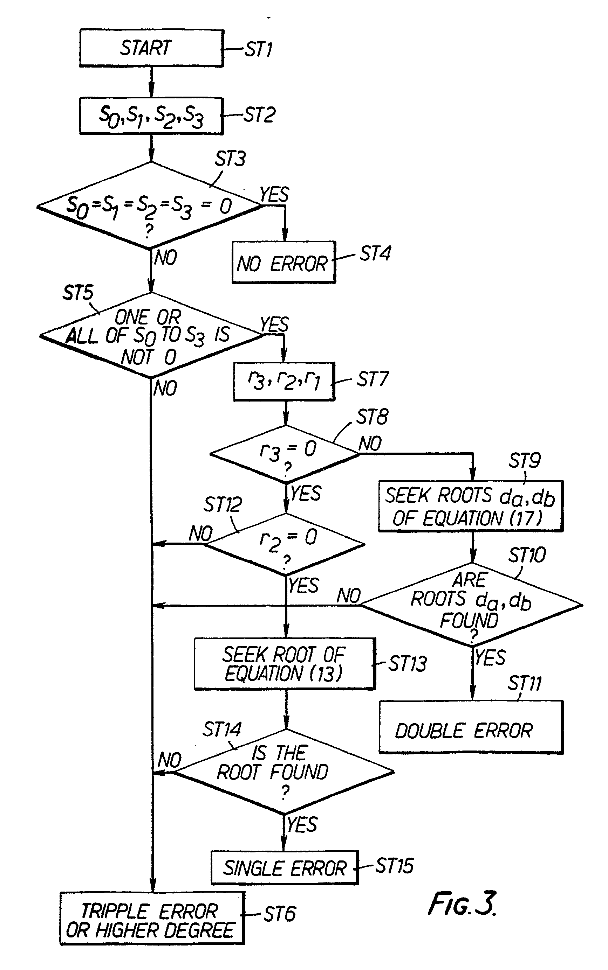

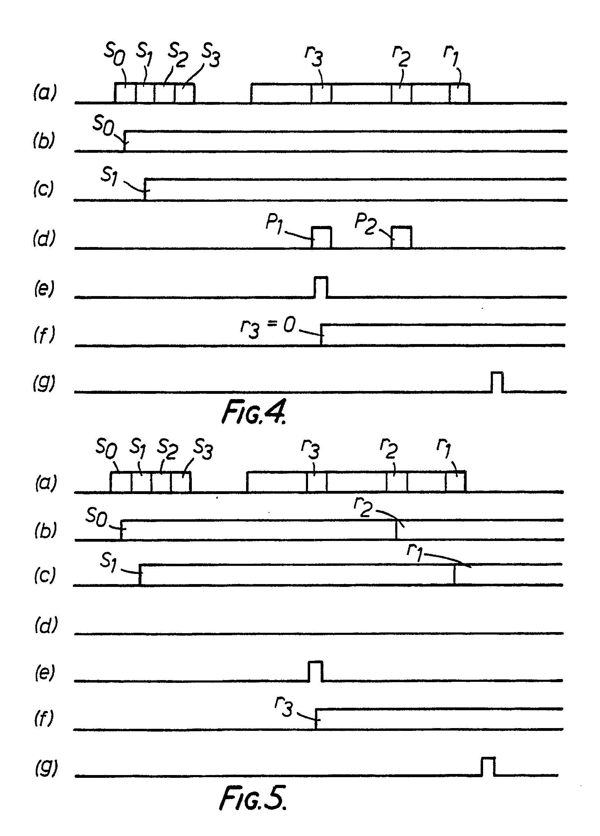

Referring now to Figs. 2 to 5, an embodiment of the present invention will be described in detail based upon the principle explained hereinbefore. Fig. 2 shows a block diagram of a circuit for solving Equations (13) and (17). The operation of the circuit will be explained with reference to a flow chart shown in Fig. 3 and timing charts shown in Figs. 4 and 5.

In Fig. 2, calculation processing circuit 17 is adpated to calculate data or signals supplied from BUS line 19 in accordance with a program stored in read only memory (referred to as ROM, hereinafter) 18, when operations are commenced at each step in the flow chart shown in Fig. 3. Calculation processing circuit 17 first calculates the syndromes $S_0$ to $S_3$ in a step $ST_2$. Calculation processing circuit 17 then delivers to BUS line 19 the syndrome $S_1$ out of the syndromes $S_0$ to $S_3$ thus determined. Meanwhile, gate circuit 20 controlled by ROM 18 delivers a latch signal to latch circuit 21, so that the first syndrome $S_1$ is latched in latch 21. Subsequently, calculation processing circuit 17 delivers to BUS line 19 the syndromes $S_0$ to $S_3$ thus produced. In consequence, gate circuit 20 delivers a latch signal to latch circuit 22 so that the syndrome $S_0$ is latched by latch circuit 22.

Calculation processing circuit 17 makes a judgement in step $ST_3$ as to whether all the syndromes $S_0$ to $S_3$ are zero. In case that the answer in YES, i.e., when all of the syndromes are zero, the symbols are judged as involving no error, i.e., that the symbols are correct, so that the answer is outputted directly without being subjected to the error judgement and error correction which are to be executed through step $ST_4$. When the answer is NO, i.e., when not all of the syndromes $S_0$ to $S_3$ are zero, calculation processing circuit 17 makes a judgement in step $ST_5$ as to whether one of the syndromes $S_0$ to $S_3$ is not zero or all of the syndromes are not zero. If the answer of this judgement is NO, a judgement is made in step $ST_6$ to

decide that the present error is of triple or of higher degree.

On the other hand, if the answer to the judgement in step $ST_5$ is YES, calculation processing circuit 17 calculates the values $r_3$, $r_2$ and $r_1$ on the basis of the syndromes $S_0$ to $S_3$ in step $ST_7$. Thereafter, a judgement is made in step $ST_5$ as to whether the value $r_3$ is zero or not. The judgement in step $ST_5$ is conducted in the following manner. First, calculation processing circuit 17 delivers $r_3$ out of the values $r_3$, $r_2$ and $r_1$ thus determined to BUS line 19: Then zero judgement circuit 23, which is under the control of ROM 18, makes a judgement whether the value $r_3$ outputted to BUS line 19 is zero. Meanwhile, the value $r_3$ delivered to BUS line 19 is latched by latch circuit 24 controlled by ROM 18. Thereafter calculation processing circuit 17 operates to deliver the values $r_2$ and $r_1$ successively to BUS line 19.

An explanation will be made first with the case where the condition: $r_3 \neq 0$ is met, i.e., with the case where the answer obtained in step ST is NO. In this case, it is judged that the error is double or triple, so that a calculation for determining the root of Equation (17) is conducted in step $ST_9$. This calculation in step $ST_9$ is conducted in a manner explained hereinafter. When the condition: $r_3 \neq 0$ is confirmed, zero judging circuit 23 operates to drive gate circuit 20 whereby latch signals are delivered to latch circuits 22 and 21 at such timing that the signals $r_1$ and $r_2$ are derived from calculation processing circuit 17. Therefore, latch circuits 22 and 21 latch the values $r_2$ and $r_1$ instead of the syndromes $S_0$ and $S_1$.

After the latching of the signals $r_3$, $r_2$ and $r_1$ in respective latch circuits 24, 21, 22, set signals r-SP are given to register circuits 25, 26, 27 which are provided to correspond to respective latch circuits 21, 22, 24, so that the signals $r_1$, $r_2$, $r_3$ latched in latch circuits 21, 22, 24 are shifted to register circuits 25, 26, 27.

Register circuit 26 is connected to multiplier circuit 28 which is adapted to operate in response to multiplication clock signal r-CK so as to multiply the content, i.e., the value $r_2$ of register circuit 26 by the error location $\alpha^i$ (in this case, $\alpha$ being $\alpha^0$ to $\alpha^{31}$) and to set the product in register circuit 26 again. On the other hand, register circuit 27 is connected to multiplier circuit 29 which operates in response to the multiplication clock signal r-CK to multiply the content, i.e., the value $r_3$ of register circuit 27 by $\alpha^2$ and to set the product again in register circuit 27.

The outputs from register circuits 25 and 26, obtained for the successive values $\alpha^0$ to $\alpha^{31}$ are added by adder 30, and the results of the addition are further added to the output from register circuit 27 by adder 31. Consequently, adder 31 produces an output which is the result of a series of calculations as shown below.

$$r_3(\alpha^0)^2 + r_2(\alpha^0) + r_1$$
$$r_3(\alpha^1)^2 + r_2(\alpha^1) + r_1$$
$$\vdots$$
$$r_3(\alpha^{31})^2 + r_2(\alpha^{31}) + r_1$$

The values $\alpha$ which make the result of the calculation zero, i.e., 0 are the root of Equation (17), i.e., the error locations $\alpha^i$ and $\alpha^j$. Consequently, a calculation for determining the root of Equation (17) is conducted. After this calculation, a judgement is made in step $ST_{10}$ as to whether two roots habe been determined. This judgement is conducted by leading the output of adder 31 to zero judging circuit 32 and judging whether the answer: 0 is obtained for two times. In case that two roots are obtained, i.e., when the answer is YES, it is judged in step $ST_{11}$ that the error is a double error, wheres, when two roots could not be obtained, i.e., when the answer is NO, it is judged in step $ST_6$ to be triple or higher degree.

In the case where the condition of $r_3 = 0$, i.e., when the answer is YES, the operation is as follows. In this case, since the error is judged to be singular or triple or of higher degree, a judgement is made in zero judging circuit 23 as to whether $r_2$ is zero in step $ST_{12}$. In the case where $r_2 \neq 0$, a judgement is made in step $ST_6$ that the error is triple or of higher degree. To the contrary, in the case of $r_2 = 0$, a calculation is conducted in step $ST_{13}$ to determine the root of Equation (13). This calculation is conducted in a manner explained hereinafter.

When the condition of $r_3 = 0$ is confirmed as a result of the judgement in zero judging circuit 23, zero judging circuit 23 operates to prohibit the operation of gate circuit 20. Therefore, the values $r_1$ and $r_2$ outputted from calculation processing circuit 17 are not latched in latch circuits 21, 22 so that latch circuits 21, 22 hold the syndromes $S_1$ and $S_0$. Then, as stated before, the contents, i.e., the values $S_1$ and $S_0$ of latch circuits 21, 22 are shifted to register circuits 25, 26, and the content $S_0$ of register circuit 26 is multiplied by the error location $\alpha$. The content $r_3$ of latch circuit 24 is shifted to register 27 and is multiplied by $\alpha^2$. Since the condition: $r_3 = 0$ is met in this case, the output from register 27 is zero. Thus, adder 31 produces an output which is obtained by a series of calculations shown below.

$$s_1 + s_0(\alpha'^0)$$
$$s_1 + s_0(\alpha'^1)$$
$$\vdots$$
$$s_1 + s_0(\alpha'^{31})$$

The value of $\alpha$ which makes the calculation result zero: 0 is the root of Equation (13), i.e., the error location $\alpha^i$. Thus, the calculation for determining the root of Equation (13) is accomplished, a judgement is made in step $ST_{14}$ as to whether one root for Equation (13) has been obtained. This is made through judging whether zero judging circuit 32 once produced an output: 0. In the case where one root has been obtained, i.e., in the case where the answer is YES, it is judged in step $ST_{15}$ that the error is a singular error. To the contrary, when the root could not be determined, i.e., when the answer is NO it is judged to be triple or of higher degree.

Figs 4 and 5 are timing charts showing the operation in the cases of $r_3 = 0$ and $r_3 \neq 0$, respectively. Referring first to the case: $r_3 = 0$, when the syndromes $S_0$ to $S_3$ are outputted from calculation processing circuit 17 at the timing shown in Fig. 4a, latch circuit 22 latches $s_0$ at the timing shown in Fig. 4b, while latch circuit 21 latches at the timing shown in Fig. 4c.

Subsequently, when the signals $r_3$ to $r_1$ are outputted from calculation processing circuit 17 at the timing shown in Fig. 4a, zero judging circuit 23 outputs a judging pulse $P_1$ for the condition: $r_3 = 0$ at a timing shown in Fig. 4d so as to inactivate gate circuit 20 thereby to prevent latching of the signals $r_2$ and $r_1$ by latch circuits 22, 21.

Meanwhile, ROM 18 delivers a latch signal to latch circuit 24 at the timing shown in Fig. 4e, so that latch circuit 24 latches the condition: $r_3 = 0$ at a timing as shown in Fig. 4f. Thereafter, if the condition: $r_2 = 0$ is met, zero judging circuit 23 delivers a judging pulse $P_2$ for the condition: $r_2 = 0$ at a timing shown in Fig. 4d.

After the calculation of the judgement of the condition: $r_2 = 0$ following the latching operation of all latch circuits 21, 22, 24, a set signal r-SP is outputted at a timing as shown in Fig. 4g, so as to permit the calculation for determining the root of Equation (13).

In the event that the condition: $r_3 = 0$, when the syndromes $S_0$ to $S_3$ are outputted at a timing shown in Fig. 5a, latch circuit 22 latches $S_0$ at the timing as shown in Fig. 5b, while latch circuit 21 latches $S_1$ at the timing shown in Fig. 5c. Then, as calculation processing circuit 17 outputs the signals $r_3$ to $r_1$ at the timings shown in Fig. 5d, the judging pulse $P_1$ for the condition: $r_3 \neq 0$ is not delivered by zero judging circuit 23 becuase the condition is so that gate circuit 20 is allowed to operate, thereby allowing latch circuits 22, 21 to latch subsequent signals $r_2$ and $r_1$. In this case, ROM 18 produces latch signals at the timing shown in Fig. 5e, while latch circuit 24 latches $r_3$ at the timing as shown in Fig. 5f. Thereafter, when calculation processing circuit 17 delivers $r_2$ and $r_1$, latch circuits 22, 21 latch the signals $r_2$ and $r_1$ in place of the syndromes $S_0$ and $S_1$.

After the completion of the latching operation of all latch circuits 21, 22, 24, a set signal r-SP is outputted at a timing shown in Fig. 5g, followed by a calculation for determining the root of Equation (17).

To sum up, the operation of the described embodiment is as follows.

As the first step, a calculation is conducted in accordance with the following equations:

$r_3 = S_1 + S_2 S_0$
$r_2 = S_1 S_2 + S_0 S_3$
$r_1 = S_2{}^2 + S_3 S_1$

When the condition: $r_3 \neq 0$ is met, a calculation is made to determine the roots of the following equation.

$r_3 x^2 + r_2 x + r_1 = 0$

When two roots are obtained, it is judged that the error is a double error and these two roots are regarded as being error locations $\alpha^i$ and $\alpha^j$. When two roots could not be obtained, it is judged that the error is a triple or of higher degree.

When the condition: $r_3 = 0$ is met, a calculation is conducted to determine the root of the following equation under the condition: $r_2 = 0$.

$S_1 + xS_0 = 0$

If one root could be obtained at the above equation, it is judged that the present error is a singular and the root is regarded as being the error location $\alpha^i$. In case of the condition: $r_2 \neq 0$ or when the root could not be obtained, it is judged that the error is triple or of higher degree. It is, therefore, possible to discriminate the singular error and double error only through the multiplication operation and the addition operation, so that it is not necessary to effect the dividing operation which is indispensable in the conventional system. Consequently, the circuit arrangement is simplified and the error judgement is conducted without failure.

In the case of a double error, the error locations $\alpha^i$ and $\alpha^j$ are determined by using Equation (17) as the polynominal. The necessity of dividing operation is eliminated also in this case, so that the simplification of the circuit arrangement is achieved also in this respect.

To the contrary, the conventional apparatus requires dividing circuits for determining the coefficients $\sigma_1$ and $\sigma_2$, because the aforementioned Equation (11) as the error location polynominal had been operated under a following equation.

$\sigma(x) = x^2 + \sigma_1 x + \sigma_2$

$= x^2 + [(S_0 S_3 + S_1 S_2)/(S_1{}^2 + S_0 S_2)]x$

$+ (S_1 S_3 + S_2{}^2)/(S_1{}^2 + S_0 S_2)$

That is, calculations for determining the coefficients $\sigma_1$ and $\sigma_2$ had to be made through the dividing operations.

According to the present invention, if $r_3 \neq 0$ Equation (13) is conducted with the syndromes $S_1$ and $S_0$ latched by latch circuits 21, 22. On the other hand, if the condition: $r_3 = 0$ is met, $r_1$ and $r_2$ are latched in place of the syndromes $S_1$ and $S_0$ to perform the calculation of Equation (17). Thus, the parts such as latch circuits 21, 22, register circuits 25, 26, multiplier circuit 28 and adder 30 are commonly used for the error location calculation for the double error. This also contributes to the simplification of the circuit arrangement and the shortening of the processing time.

Futhermore, if the condition $r_3 = 0$ is met, the syndromes $S_1$ and $S_0$ latched by latch circuit 21, 22 remain latched by these circuits and the calculation of Equation (13) is executed. However, when the condition: $r_3 \neq 0$ is met, the calculation of equation (17) is executed with the values $r_1$ and $r_2$ latched in place of the syndromes $S_1$ and $S_0$. Consequently, the parts such as latch circuits 21, 22, register circuits 25, 26, multiplier circuit 28 and adder 30 can be used commonly both for the calculation of the error location for a singular error and the calculation of the error location for a double error. This constitutes one of the advantageous features of the present invention.

After determination of the root of Equation (13) in step $ST_{14}$, a judgement is made in step $St_{14}$ as to whether one root has been determined. When one root has been obtained, it is judged that the error is a singular error, wheres, when one root could not be obtained, it is judged that the error is triple or of higher degeree. It is, therefore, possible to prevent any erroneous judgement of the singular error with a high accuracy. Namely, when an error which is quadruple is erroneously judged as a singular error, the one root may not be obtained because of the conditions: $r_3 = 0$ and $r_2 = 0$ being met. In the case where the number n of symbols of the correcting block is 32, while the Galois field isGF$(2^8)$, the probability of the erroneous judgement of the quadruple error or error of higher degree for singular error can be nullified advantageously.

As will be fully realized from the foregoing description, it is possible to provide an error correction circuit which can perform an error correction without failure with quite a simple circuit arrangement.

## Claims

1. An error correction circuit for detecting and correcting a plurality of errors in codewords made up of k data and n - k inspection symbols in the playback data from a recording medium each symbol made up of m binary bits of information using a Reed-Solomon code for error detection and correction so that the error location polynominal is $\sigma(x) = x^e + \sigma_1 x^{e-1} + ... + \sigma_e$ where e is the number of errors and the coefficients $\sigma_1$ to $\sigma_e$ of the error location polynominal $\sigma(x)$ are related to the error syndromes $S_i$ generated by the error correction circuit by the equation

$S_{i+e} + \sigma_1 S_{i+e-1} + ... + \sigma_{e-1} S_{i+1} + \sigma_e S_i = 0$

where the syndromes $S_{i+e}$ to $S_i$ are field elements $\alpha^i$ of the Galois field GF$(2^m)$, the error correction circuit comprising:

EP 0 136 587 B1

means (12) for generating syndromes $S_0$, $S_1$, $S_2$ and $S_3$ from the codewords;

first and second means (21,22) for holding the syndromes $S_1$ and $S_0$;

means (17) for effecting the following three calculations on the basis of the syndromes $S_0$, $S_1$, $S_2$ and $S_3$ generated by said syndrome generating means

$$S_2S_0 + S_1{}^2 = r_3$$
$$S_3S_0 + S_1S_2 = r_2$$
$$S_3S_1 + S_2{}^2 = r_1$$

where $r_3$, $r_2$ and $r_1$ represent the values of the respective calculations;

third means (24) for holding the value $r_3$;

means for judging (23) whether the condition $r_3 \neq 0$ or $r_3 = 0$;

a control means for making, when the condition $r_3 \neq 0$ is confirmed by said judging means, said first and second holding means hold the values $r_1$ and $r_2$ in place of the syndromes $S_1$ and $S_0$; and

means (17) for processing signals to find error locations by determining the root of the following equation as the error location polynominal

$$r_3x^2 + r_2x + r_1 = 0 \text{ or}$$
$$S_1 + S_0x = 0$$

wherein said calculation effecting means is adapted to calculate first sums by adding to the content of said first holding means (21) successively obtained by multiplying the content of said second holding means (22) successively by the elements $\alpha$ of said Galois field GF ($2^m$) and to provide second sums by adding to each first sum a value obtained by multiplying the content of said third holding means (24) by $\alpha^2$, whereby that element $\alpha$ which results in a value of zero of a said second sum is used as the error location.

## Revendications

1. Un circuit de correction d'erreur destiné à détecter et à corriger un ensemble d'erreurs dans des mots de code qui sont constitués par k symboles de données et n-k symboles de contrôle, dans les données reproduites à partir d'un support d'enregistrement, chaque symbole constitué par m bits d'information utilisant un code de Reed-Solomon pour la détection et la correction d'erreur, de façon que le polynôme de position d'erreur soit $\sigma(x) = x^e + \sigma_1x^{e-1} + \ldots \sigma_e$, en désignant par e le nombre d'erreurs, et les coefficients $\sigma_1$ à $\sigma_e$ du polynôme de position d'erreur o(x) étant liés aux syndromes d'erreur $S_i$ qui sont générés par le circuit de correction d'erreur, par la relation :

$$S_{i+e} + \sigma_1S_{i+e-1} + \ldots \sigma_{e-1}S_i{+}1 + \sigma_eS_i = 0$$

dans laquelle les syndromes $S_{i+e}$ à $S_i$ sont des éléments de champ $\alpha^i$ du champ de Galois GF($2^m$), le circuit de correction d'erreur comprenant :

des moyens (12) pour générer des syndromes $S_0$, $S_1$, $S_2$ et $S_3$ à partir des mots de code;

des premiers et seconds moyens (21, 22) pour conserver les syndromes $S_1$ et $S_0$;

des moyens (17) pour effectuer les trois calculs suivants sur la base des syndromes $S_0$, $S_1$, $S_2$ et $S_3$ qui sont générés par les moyens de génération de syndrome :

$$S_2S_0 + S_1{}^2 = r_3$$
$$S_3S_0 + S_1S_2 = r_2$$
$$S_3S_1 + S_2{}^2 = r_1$$

les quantités $r_3$, $r_2$ et $r_1$ représentant les valeurs des calculs respectifs;

des troisièmes moyens (24) pour conserver la valeur $r_3$;

des moyens (23) pour déterminer si la condition $r_3 \neq 0$ ou $r_3 = 0$ est vérifiée;

des moyens de commande qui, lorsque la condition $r_3 \neq 0$ est confirmée par les moyens de détermination, commandent aux premiers et seconds moyens de conservation de conserver les valeurs $r_1$ et $r_2$ à la place des syndromes $S_1$ et $S_0$; et

des moyens (17) pour traiter des signaux de façon à trouver des positions d'erreur en déterminant la racine de l'équation suivante, correspondant au polynôme de position d'erreur :

$$r_3x^2 + r_2x + r_1 = 0 \text{ ou}$$
$$S_1 + S_0x = 0$$

les moyens de calcul étant conçus de façon à calculer des premières sommes en additionnant successivement au contenu des premiers moyens de conservation (21) une valeur qui est obtenue en multipliant successivement le contenu des seconds moyens de conservation (22) par les éléments $\alpha$ du champ de Galois GF($2^m$) et à fournir des secondes sommes en additionnant à chaque première somme une valeur qui est obtenue en multipliant par $\alpha^2$ le contenu des troisièmes moyens de conservation, et l'élément $\alpha$ qui donne une valeur égale à zéro pour la seconde somme étant utilisé à titre de position d'erreur.

**Ansprüche**

1. Fehlerkorrekturschaltung zur Feststellung und Korrektur einer Vielzahl von Fehlern in Codewörtern, die sich aus k Daten und n - k Prüfsymbolen zusammensetzen, in Wiedergabedaten von einem Aufzeichnungsmedium, wobei sich jedes Symbol aus m binären Informationsbits zusammensetzt, und wobei ein Reed-Solomon Code zur Fehlerfeststellung und -korrektur verwendet wird, so daß das Fehlerortungspolynom $\sigma(x) = x^e + \sigma_1 x^{e-1} + \ldots + \sigma_e$ ist, wobei e die Anzahl von Fehlern und die Koeffizienten $\sigma_1$ bis $\sigma_e$ des Fehlerortungspolynoms $\sigma(x)$ mit den von der Fehlerkorrekturschaltung erzeugten Fehlersyndromen $S_i$ gemäß der Gleichung

$$S_{i+e} + \sigma_1 S_{i+e-1} + \ldots + \sigma_{e-1} S_{i+1} + \sigma_e S_i = 0$$

in Beziehung stehen, wobei die Syndrome $S_{i+e}$ bis $S_i$ Feldelemente $\alpha^i$ des Galoisfeldes $GF(2^m)$ sind und die Fehlerkorrekturschaltung umfaßt:

eine Anordnung (12) zur Erzeugung von Syndromen $S_0$, $S_1$, $S_2$ und $S_3$ aus den Codewörtern,

eine erste und eine zweiten Anordnung (21, 22) zum Halten der Syndrome $S_1$ und $S_0$,

eine Anordnung (17) zur Ausführung der folgenden drei Berechnungen auf der Basis der Syndrome $S_0$, $S_1$, $S_2$ und $S_3$, die von der Syndromerzeugungsanordnung erzeugt wurden

$$S_2 S_0 + S_1^2 = r_3$$
$$S_3 S_0 + S_1 S_2 = r_2$$
$$S_3 S_1 + S_2^2 = r_1$$

wobei $r_3$, $r_2$ und $r_1$ die Werte der jeweiligen Berechnungen repräsentieren, eine dritte Anordnung (24) zum Halten des Werts $r_3$,

eine Anordnung (23) zur Beurteilung ob die Bedingung $r_3 \neq 0$ oder $r_3 = 0$ erfüllt ist,

eine Steueranordnung, die bewirkt, wenn die Beurteilungsanordnung bestätigt, daß die Bedingung $r_3 \neq 0$ erfüllt ist, daß die erste und die zweite Halteanordnung die Werte $r_1$ und $r_2$ anstelle der Syndrome $S_1$ und $S_0$ halten, und

eine Anordnung (17) zur Verarbeitung von Signalen zur Ermittlung von Fehlerorten durch Bestimmen der Wurzel der folgenden Gleichung als dem Fehlerortungspolynom

$$r_3 x^2 + r_2 x + r_1 = 0 \text{ oder}$$
$$S_1 + S_0 x = 0$$

wobei die Berechnungsausführungsanordnung so ausgebildet ist, daß sie erste Summen errechnet, indem sie zum Inhalt der ersten Halteanordnung (21) sukzessive einen Wert addiert, der durch sukzessives Multiplizieren des Inhalts der zweiten Halteanordnung (22) mit den Elementen $\alpha$ des Galoisfeldes $GF(2^m)$ erhalten wird, und zweite Summen liefert, indem sie zu jeder ersten Summe einen Wert addiert, der durch Multiplizieren des Inhalts der dritten Halteanordnung (24) mit $\alpha^2$ erhalten wird, wobei dasjenige Element $\alpha$, das zu einem Wert Null der zweiten Summe führt, als Fehlerort dient.

12

PICK-UP 11

DEMODULATOR 12

ERROR CORRECTION CIRCUIT 13

DOUBLE ERROR CORRECTION CIRCUIT 14

DE-INTER LEAVE CIRCUIT 15

DOUBLE ERROR CORRECTION CIRCUIT 16

Ef

Ef

FIG. I.

FIG.2.

FIG.3.

FIG.4.

FIG.5.